Europäisches Patentamt

European Patent Office

Office européen des brevets

(19)

(11) Veröffentlichungsnummer : **0 116 261 B2**

# (12) NEUE EUROPÄISCHE PATENTSCHRIFT

(45) Veröffentlichungstag der neuen Patentschrift :
**22.01.92 Patentblatt 92/04**

(51) Int. Cl.$^5$ : **H05K 7/18, A47B 96/14**

(21) Anmeldenummer : **83810615.1**

(22) Anmeldetag : **23.12.83**

(54) Bausatz zur Erstellung von Montagerosten für Geräte und Verwendung desselben.

(30) Priorität : **10.01.83 CH 108/83**

(43) Veröffentlichungstag der Anmeldung :
**22.08.84 Patentblatt 84/34**

(45) Bekanntmachung des Hinweises auf die
Patenterteilung :
**06.08.86 Patentblatt 86/32**

(45) Bekanntmachung des Hinweises auf die
Entscheidung über den Einspruch :
**22.01.92 Patentblatt 92/04**

(84) Benannte Vertragsstaaten :
**AT BE DE FR GB IT NL SE**

(56) Entgegenhaltungen :
**CH-A- 438 449**
**CH-A- 581 396**
**DE-A- 2 731 328**
**FR-A- 2 292 357**

(56) Entgegenhaltungen :
**Prospekt APM 77 der Firma Wyser + Amliker**
**Prospekt SR 79 der Firma Wyser + Anliker**
**Prospekt AK 71 der Firma Wyser + Anliker**
**Prospekt SR 72 der Firma Wyser + Anliker**
**Prospekt der Firma Pestalozzi + Co. AG, August 1981, S. 4+5**
**Zeichnung WP-18572 aus dem Jahr 1967 für das Profil Nr. R 12280**

(73) Patentinhaber : **S. Schmied & Co.**
**elektrotechnische Bedarfsartikel en gros,**
**ASM-Tableaubau**
**Zelgstrasse 93**
**CH-3138 Uetendorf (CH)**

(72) Erfinder : **Schmied, Samuel**
**Zelgstrasse 93**
**CH-3138 Uetendorf (CH)**

(74) Vertreter : **Steiner, Martin et al**
**c/o AMMANN PATENTANWÄLTE AG BERN**
**Schwarztorstrasse 31**
**CH-3001 Bern (CH)**

## Beschreibung

Die vorliegende Erfindung betrifft einen Bausatz gemäss Oberbegriff des Anspruchs 1. Es sind verschiedene Profilsätze bekannt, die alle zum Bau von Gerippen von Geräteschränken dienen, welche Gerippe mit einer eigentlichen Schrankverkleidung verbunden werden müssen.

Die DE-A-2 731 328 zeigt Kastenprofile, die an zwei benachbarten Kastenseiten eine halboffene Nut bildende Fortsätze aufweisen. Die Fortsätze können der Befestigung von Montageschienen dienen. Ausserhalb der Fortsätze sind besondere Wand-, Decken- oder Bodenelemente zu montieren.

Die CH-A-581 396 zeigt ähnliche Kastenprofile zur Bildung von Gerippen, mit welchen die Wand-, Decken- und Bodenelemente verbunden werden müssen.

Die FR-A-2 292 357 zeigt winkelförmige Kastenprofile zur Erstellung von Gerippen von Geräteschränken, mit welchen ebenfalls besondere Wand- und Deckenelemente verbunden werden müssen. Die Profile eignen sich nicht zum direkten, einfachen Anbringen von Montageprofilen für Geräte. Aus dem Prospekt APM77 der Fa. Wyser + Anliker, Zürich, ist ein Bausatz zur Erstellung von Montagerosten für Geräte mit zur Bildung von Kastenwänden bemessenen Profilen, mit in an der Innenseite der Profile befindliche Nuten einschiebbaren Muttern und mit denselben verwendbaren Schrauben bekannt, bei dem als Profile Grundprofile vorgesehen sind, die zur direkten Bestimmung der Höhe von Montageprofilen für Apparate und derjenigen einer Abdeckung über einer Montageunterlage geeignete Nuten aufweisen, wobei die Grundprofile zwei rechtwinklig zueinander stehende Schenkel aufweisen, von welchen der kürzere, der Montage auf der Montageunterlage dienende Schenkel eine quer zu diesem Schenkel nach innen offene Nut und der andere Schenkel an seinem Ende eine auswärts offene Nut und innerhalb desselben mindestens eine quer zum anderen Schenkel nach innen offene Nut aufweist.

Ziel der Erfindung ist es, einen Bausatz mit Profilen anstatt zur Erstellung von Gerippen von Geräteschränken zur besonders einfachen Erstellung von Montagerosten und -kästen für Geräte, insbesondere elektrische Geräte, zur direkten Montage auf einer Unterlage zu schaffen. Der Bausatz soll einerseits mit einem Minimum an Zubehör auskommen und die Verwendung der Profile selbst als Kastenwände gestatten. Das angestrebte Ziel wird durch einen Bausatz gemäss Anspruch 1 erreicht. Die nach innen offene Nut am kürzeren, der Montage auf der Unterlage dienenden Schenkel, gestattet die direkte Befestigung von Montageprofilen ohne besondere Hilfsmittel ausser den erwähnten Muttern und Schrauben in der gewünschten Höhe über der Unterlage. Die längeren Schenkel der Grundprofile können direkt als Aussenwand eines Kastens oder Rahmens dienen, und ihre nach aussen, bzw. oben offenen Nuten dienen der Befestigung einer Abdeckung wiederum mit den Grundbefestigungsmitteln, nämlich Muttern und Schrauben. Die nach innen offene Nut in den längeren Schenkeln dient der eventuellen Befestigung von Unterteilungsprofilen mit einfachsten Mitteln wie genormten Winkeln.

Vorzugsweise können besondere Rahmenprofile vorgesehen sein, deren Querschnitt dem die beiden Nuten umfassenden Teil des erwähnten längeren Schenkels des Grundprofils entspricht. Dieses Rahmenprofil kann als Wandteil geringerer Höhe verwendet werden, der zwischen sich und der Unterlage eine Öffnung zum Einführen von Leitungen bildet.

Die Erfindung wird nun anhand eines Ausführungsbeispiels näher erläutert.

Figur 1 zeigt in räumlicher Ansicht, teilweise im Schnitt, einen Ausschnitt aus einem Verteilkasten,
Figuren 2 bis 4 zeigen in Figur 1 verwendete Profile,
Figur 5 zeigt einen Schnitt durch eine Eckverbindung,
Figur 6 zeigt eine zweite Ausführungsform eines Grundprofils mit angeschlossenen Teilen, und
Figuren 7 und 8 zeigen Profile zur direkten Montage in einem bestehenden Verteilkasten.

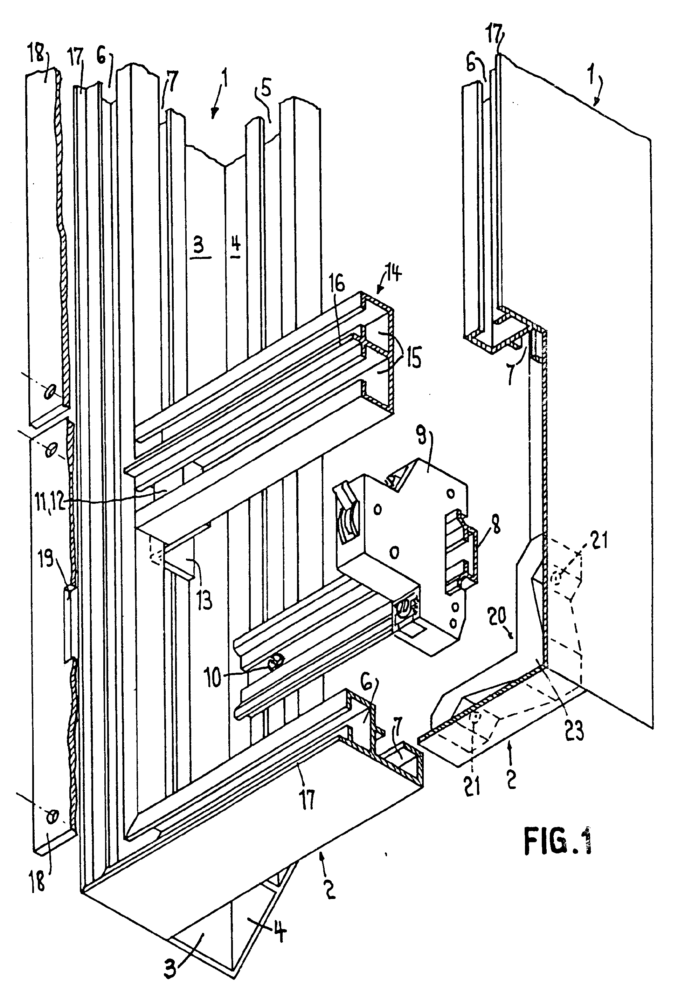

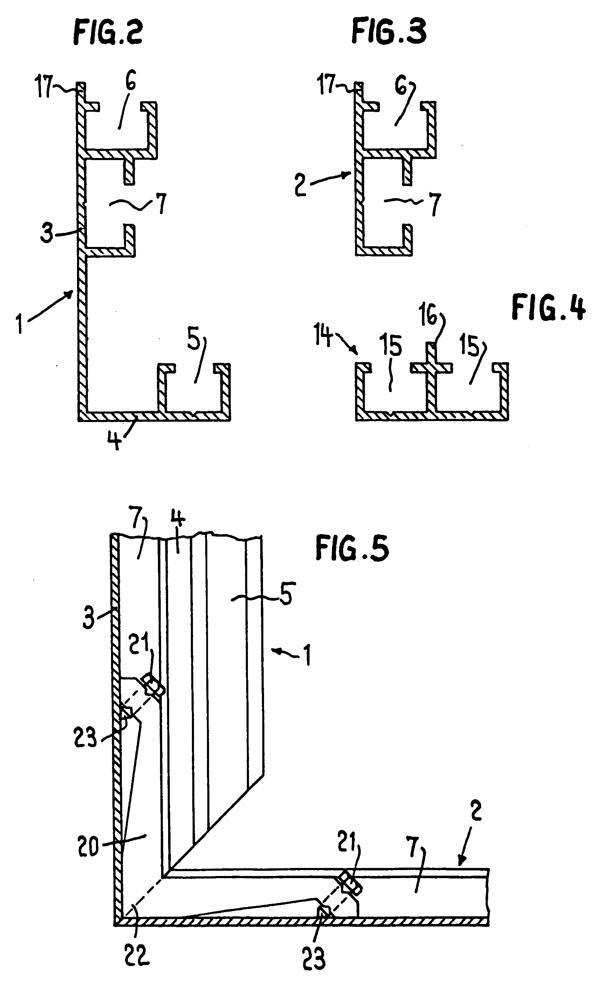

Der in Figur 1 teilweise dargestellte Verteilkasten weist einen Rahmen auf, dessen seitliche senkrechte Holme aus Grundprofilen 1 der in Figur 2 dargestellten Querschnittsform bestehen. Ein unterer horizontaler Querholm besteht aus einem Profil 2 der in Figur 3 dargestellten Querschnittsform. Der obere, nicht dargestellte horizontale Querholm des Rahmens kann aus einem Profil 1 oder Profil 2 bestehen.

Das Grundprofil 1 weist rechtwinklig zueinanderstehende Schenkel 3 und 4 auf, wobei, gemäss Figuren 1 und 2, der Schenkel 4 zur Montage des Rahmens auf eine nicht dargestellte Unterlage dient. Das Profil 1 weist am äusseren Ende des Schenkels 4 eine halboffene Nut 5 mit quer zum Schenkel 4 gerichteter Öffnung auf. Eine entsprechend gerichtete und dimensionierte Nut 6 befindet sich am oberen Ende des Schenkels 3. Unmittelbar unterhalb der Nut 6 befindet sich eine Nut 7 mit quer zum Schenkel 3 liegender Öffnung. Das Profil 2 entspricht dem oberen Teil mit den Nuten 6 und 7 des Profiles 1, und diese Nuten sind auch entsprechend bezeichnet.

Wie Figur 1 zeigt, dienen die unteren Nuten 5 der direkten Befestigung von horizontal liegenden Normprofilen 8, auf welche Reihen von Geräten, beispielsweise Sicherungselementen oder Leitungsschutzschaltern 9, wie in Figur 1 eines dargestellt ist, in bekannter Weise aufgeschnappt werden können. Zur Verbindung der

2

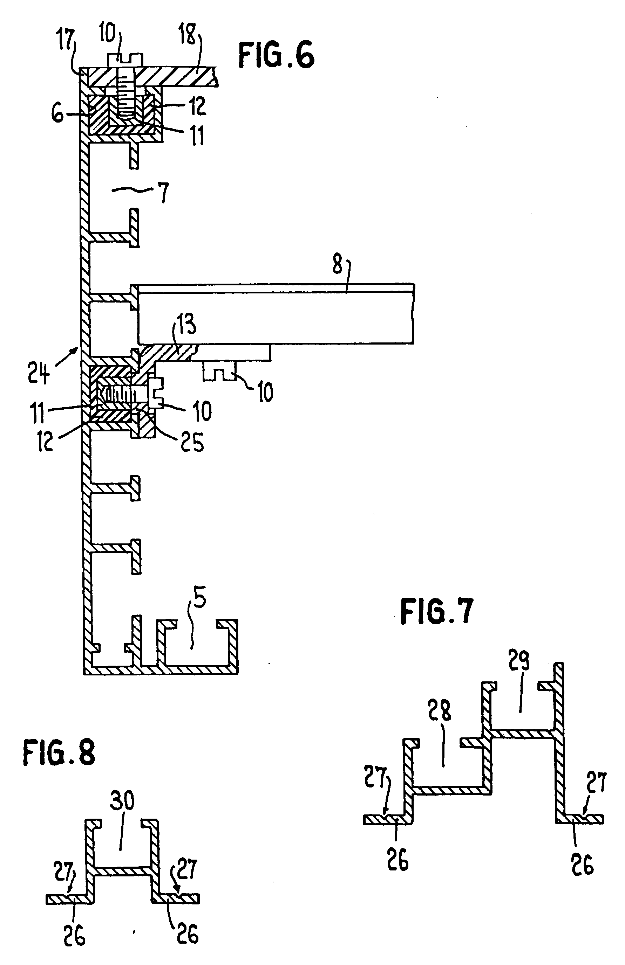

Profile 1 und 8 werden in die Nuten 5 der beiden seitlichen Profile 1 Muttern mit Kunststoffmantel eingeschoben, mit welchen Befestigungslöcher des Profils 8 durchsetzende Schrauben 10 verschraubt sind. Derartige Befestigungen mittels Muttern 11 mit Kunststoffmantel 12, welche mit leichter Reibung in die Nuten eingeschoben werden können, und Schrauben 10 sind in Figur 6 beispielsweise dargestellt. Diese Befestigungsart wird generell angewendet. Das Niveau der Oberseite der die Nut 5 bildenden seitlichen Flansche des Profils ist so gewählt, dass gemäss Figur 1 aufgesetzte Normprofile 8 ohne weitere Korrektur die richtige Höhe im Rahmen, bzw. im Verteilkasten aufweisen. Mit je einer in gegenüberliegende Nuten 7 der Profile 1 eingeschobenen Mutter 11, 12 sind Montagewinkel 13 verschraubt, und auf diese Montagewinkel ist ein horizontal liegendes Unterteilprofil 14 aufgesetzt, dessen Querschnitt in Figur 4 dargestellt ist. Dieses Profil weist zwei nebeneinanderliegende, nach der gleichen Seite offene Nuten 15 und einen dazwischenliegenden, über die Nutenöffnungen hinaus verlängerten Steg 16 auf. Wie aus Figur 1 ersichtlich, liegen die Nuten 15 auf demselben Niveau wie die Nuten 6 der Profile 1, und der Steg 16 des Profils 14 liegt ebenfalls auf dem gleichen Niveau wie ein über die Nut 6 emporragender Steg 17. Die Nuten 6 und 15 dienen der Befestigung von Abdeckplatten 18 aus Kunststoff oder sonstigem geeigneten Material. Wie in Figur 1 angedeutet, weisen diese Platten geeignete Fenster 19 auf, durch welche die Geräte 9 durchragen oder wenigstens sichtbar sind. Die Abdeckplatten 18 werden ebenfalls mit Muttern 11, 12 verschraubt, welche in die Nuten 6 bzw. 15 eingeschoben sind. Auch die Verbindung des Profils 14 mit den Winkeln 13 erfolgt mittels Muttern 11, 12 und Schrauben 10.

Zur Eckverbindung zwischen je einem Profil 1 und einem Profil 2 wird, wie in den Figuren 1 und 5 gezeigt, ein Verbindungswinkel 20 in die entsprechenden Nuten 7 der auf Gehrung geschnittenen Profilenden eingeschoben. An den Enden des Winkels 20 sind schiefstehende Schrauben 21 eingesetzt, die je eine zum Scheitel 22 des Verbindungswinkels 20 hin gerichtete Spitze 23 aufweisen. Nach dem Einführen des Verbindungswinkels 20 und dem möglichst satten Zusammenschieben der auf Gehrung geschnittenen Stirnflächen der zu verbindenden Profile werden die Schrauben 21 festgezogen, wobei deren Spitzen 23 am Grund der Nuten 7 in das Profilmaterial, vorzugsweise Aluminium, eindringen und damit die Profile mit ihren Stirnflächen fest gegeneinanderpressen und in dieser Lage festhalten. Es wird damit einfach und rasch mit ebenfalls sehr einfachen Mitteln eine tadellose Eckverbindung der Profile erzielt.

Zwischen dem Profil 2 und der nicht dargestellten Unterlage verbleibt gemäss Figur 1 eine Öffnung, durch welche Drähte, Rohre, Kabel und dgl. in den Kasten durchgeführt werden können. Sind alle Zu- und Wegleitungen beispielsweise unter Putz verlegt, kann anstelle des Profils 2 ein Profil 1 verwendet werden, um einen allseitig bis an die Montageunterlage geschlossenen Rahmen, bzw. Kasten zu erzielen.

Aus der vorstehenden Beschreibung geht hervor, dass ausser den Profilen 1, 2 und 14 sowie dem allgemein verwendeten Normprofil 8 und den allgemein verwendeten Muttern 11, 12 und Schrauben 10 als weiteres Zubehör nur der Winkel 13 erforderlich ist. Verteilanlagen beliebiger Dimensionen können somit unter Verwendung einfacher Bauteile besonders rationell erstellt werden. Irgendwelche besonderen Anpassarbeiten sind unnötig.

Figur 6 zeigt ein Grundprofil 24, das dem Profil 1 insofern entspricht, als es zwei rechtwinklig stehende Schenkel mit Nuten 5, 6 und 7, entsprechend den gleich bezeichneten Nuten des Profils 1, aufweist. Das Profil 24 ist jedoch wesentlich höher, so dass auf verschiedenen Niveaux Normprofile 8 angebracht werden können. Aus Figur 6 ist ersichtlich, dass der Winkel 13 zur Bildung eines spielarm in die Nutenöffnung greifenden Vorsprungs 25 verformt ist, womit die Lage des Winkels genau bestimmt ist. Figur 6 zeigt auch die Befestigung einer Deckplatte 10.

Die Figuren 7 und 8 zeigen Profile, die dazu bestimmt sind, am Boden bestehender Verteilkästen oder dgl. direkt montiert zu werden. Diese Profile weisen je zwei seitliche Flansche 26 auf, die mit Bohrnuten 27 zum Ansetzen eines Bohrers für Befestigungslöcher versehen sind. Das Profil gemäss Fig. 7 weist zwei in der Höhe versetzte Nuten 28 und 29 auf, die der Befestigung von anderen Profilen auf dem gewünschten Niveau dienen. Das Profil nach Figur 8 weist nur eine einzige Nut 30 zur Befestigung weiterer Profile, insbesondere von Normprofilen 8, in geeigneten Höhe, auf.

Es sind verschiedene Ausführungsvarianten möglich. Die Eckverbindungen können in anderer, herkömmlicher Weise erstellt werden. Andererseits kann die dargestellte und beschriebene Art der Eckverbindung auch in ganz anderem Zusammenhange mit Vorteil angewendet werden.

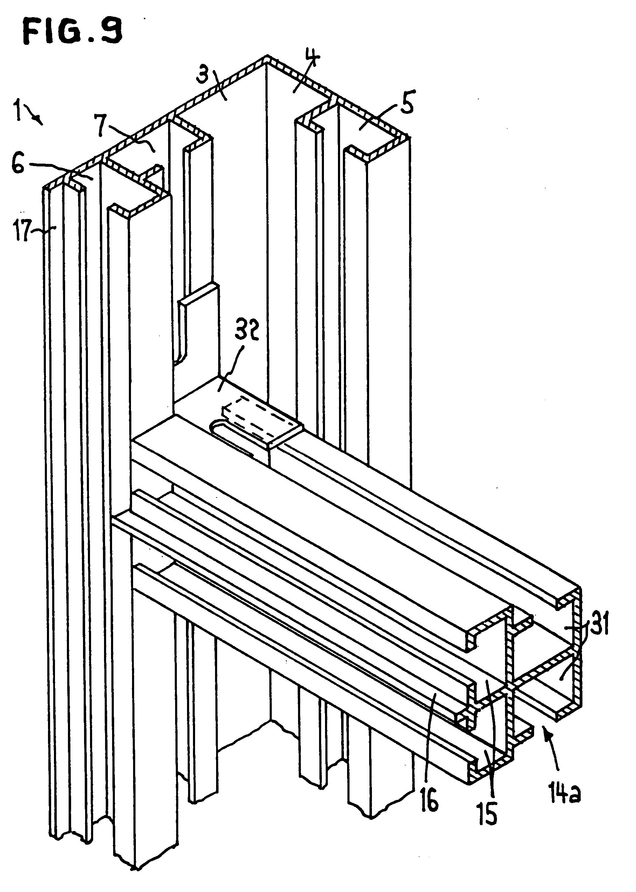

Figur 9 zeigt eine vorteilhafte Variante 14a des Unterteilprofils 14 nach Figur 4. Diese Profilvariante weist an der Rückseite der Nuten 15 zwei symmetrisch liegende, nach entgegengesetzten Seiten offene Nuten 31 auf, deren Öffnungen quer zu denjenigen der Nuten 15 liegen. Während im Profil 14 gemäss Figur 1 Löcher gebohrt werden müssen, um dieses Profil mit dem Grundprofil 1 mittels Winkeln 13 zu verbinden, kann das Profil 14a dank den Nuten 31 mittels Winkeln 32 z.B. mit dem Grundprofil 1 verbunden werden, ohne Löcher zu bohren. Die Nuten 31 können jedoch auch anderen Zwecken dienen, z.B. der Befestigung von Verstrebungen, Stützen und dergleichen.

**EP 0 116 261 B2**

**Patentansprüche**

1. Bausatz zur Erstellung von Montagerosten für Geräte, mit zur Bildung von Kastenwänden bemessenen Profilen (1,2), mit in an der Innenseite der Profile befindliche halboffene Nuten (5,6,7) einschiebbaren Muttern (11,12) und mit denselben verwendbaren Schrauben (10) und mit in die Nuten einschiebbaren Verbindungswinkeln (20) zur Eckverbindung der Profile, bei dem als Profile Grundprofile (1) vorgesehen sind, die zur direkten Bestimmung der Höhe von Montageprofilen (8) für Apparate (9) und derjenigen einer Abdeckung (18) über einer Montageunterlage geeignete Nuten aufweisen, wobei die Grundprofile (1) zwei rechtwinklig zueinander stehende Schenkel (3,4) aufweisen, von welchen der kürzere, der Montage auf der Montageunterlage dienende Schenkel (4) eine quer zu diesem Schenkel nach innen offene, zur Befestigung von Montageprofilen (8) geeignete Nut (5) und der andere Schenkel (3) an seinem Ende eine auswärts offene, zur direkten Befestigung der Abdeckung (18) mittels Muttern (11,12) und Schrauben (10) geeignete Nut (6) und innerhalb desselben mindestens eine quer zum anderen Schenkel (3) nach innen offene, zur Aufnahme eines Schenkels des Verbindungswinkels (20) geeignete Nut (7) aufweist, bei dem ferner ein Rahmenprofil (2) vorgesehen ist, dessen Querschnitt dem die beiden Nuten (6,7) umfassenden Teil des erwähnten anderen Schenkels (3) des Grundprofils (1) entspricht, und bei dem ein Unterteilungsprofil (14) mit zwei nach der gleichen Seite offenen Nuten (15) zum Einschieben von Muttern zwecks Befestigung der Abdeckung (18) sowie ein Verbindungswinkel (13) zur Verbindung des Unterteilungsprofils (14) in vorbestimmbarer Höhe mit der quer zum anderen Schenkel (3) nach innen offenen Nut (7) vorgesehen ist, derart, dass die Nuten (15) des Unterteilungsprofils auf demselben Niveau liegen wie die auswärts offene Nut (6) des anderen Schenkels.

2. Bausatz nach Anspruch 1, gekennzeichnet durch ein Unterteilungsprofil (14) mit einem zwischen den Nutenöffnungen über dieselben vorstehenden Steg (16).

3. Bausatz nach einem der Ansprüche 1 oder 2, dadurch gekennzeichnet, dass eine einzige Art von Winkel (13) zur Verbindung eines Montage- (8) oder eines Unterteilungsprofils (14) mit einem Grundprofil (1) vorhanden ist.

4. Bausatz nach einem der Ansprüche 1 bis 3, gekennzeichnet durch ein weiteres Profil mit zwei seitlichen Montageschenkeln (26) und dazwischen einer quer zu den Montageschenkeln offenen Nut (30) (Fig. 8).

5. Bausatz nach einem der Ansprüche 1 bis 4, gekennzeichnet durch ein weiteres Profil mit zwei seitlichen Montageschenkeln (26) und dazwischen zwei auf unterschiedlichem Niveau liegenden, quer zu den Schenkeln offenen Nuten (28, 29) (Fig. 7).

6. Bausatz nach einem der Ansprüche 1 bis 5, dadurch gekennzeichnet, dass der Verbindungswinkel (20) für Grundprofile (1) oder Rahmenprofile (2) je eine geneigte, mit einer Spitze (23) gegen den Nutengrund pressbare Spannschraube (21) aufweist.

**Revendications**

1. Jeu de construction pour l'établissement de cadres de montage pour appareils, comportant des profilés (1,2) dimensionnés pour la formation des parois d'un coffret, des écrous (11,12) enfichables dans des rainures semi-ouvertes (5,6,7) disposées sur le côté intérieur des profilés et des vis (10) utilisables avec les écrous, et des cornières de connexion (20) enfichables dans les rainures, pour l'assemblage angulaire des profilés, dans lequel sont prévus parmi les profilés des profilés de base (1) comportant des rainures appropriées pour déterminer directement la hauteur au-dessus d'une base de montage de profilés de montage (8) pour appareils (9) et d'une couverture (18), les profilés de base (1) comprenant deux montants (3,4) perpendiculaires l'un à l'autre dont le montant plus court (4) servant au montage sur la base de montage, comporte une rainure (5) ouverte vers l'intérieur perpendiculairement à ce montant et appropriée à la fixation de profilés de montage (8) et l'autre montant comprend à son extrémité une rainure (6) ouverte vers l'extérieur qui est appropriée à la fixation directe de la couverture (18) au moyen d'écrous (11,12) et de vis (10), et intérieurement de cette dernière, au moins une rainure (7) ouverte vers l'intérieur perpendiculairement audit autre montant (3), qui est susceptible de recevoir un côté de la cornière de connexion (20), dans lequel est prévu en plus un profilé de cadre (2) dont la coupe transversale correspond à la partie dudit autre montant (3) du profilé de base qui comprend les deux rainures (6,7), et dans lequel est prévu un profilé de compartimentage (14) avec deux rainures (15) ouvertes du même côté pour introduire des écrous aux fins de fixer la couverture (18) ainsi qu'une cornière de connexion (13) pour relier le profilé de compartimentage (14) à la rainure (7) ouverte vers l'intérieur perpendiculairement audit autre montant (3) à une hauteur pouvant être prédéterminée, de sorte que les rainures (15) du profilé de compartimentage sont situées au même niveau que la rainure (6) extérieurement ouverte de l'autre montant.

2. Jeu de construction selon la revendication 1, caractérisé par un profilé de compartimentage (14) avec une traverse entre les ouvertures des rainures qui dépasse de celles-ci.

4

3. Jeu de construction selon l'une des revendications 1 ou 2, caractérisé en ce qu'une seule sorte de cornière (13) est prévue pour connecter un profilé de montage (8) ou de compartimentage (14) avec un profilé de base (1).

4. Jeu de construction selon l'une des revendications 1 à 3, caractérisé par un profilé supplémentaire avec deux montants de montage (26) et entre ceux-ci une rainure (30) ouverte perpendiculairement aux montants de montage (fig. 8).

5. Jeu de construction selon l'une des revendications 1 à 4, caractérisé par un profilé supplémentaire avec deux montants de montage (26) et entre ceux-ci deux rainures (28,29) situées à des niveaux différents et ouvertes perpendiculairement aux montants de montage (fig. 7).

6. Jeu de construction selon l'une des revendications 1 à 5, caractérisé en ce que la cornière de connexion (20) pour les profilés de base (1) ou les profilés de cadre (2) comporte chaque fois une vis de serrage (21) inclinée dont une pointe (23) est capable d'être pressée contre le fond de la rainure.

## Claims

1. Construction set for the erection of mounting frames for apparatus, comprising profiles (1,2) which are dimensioned for the formation of casing walls, nuts (11,12) which are insertable in half-open grooves (5,6, 7) disposed on the inside of said profiles and screws (10) which are used therewith, and connecting angles (20) which are insertable into the grooves in order to connect the profiles at the corners, wherein among said profiles, basic profiles (1) are provided which have grooves suitable for direct setting of the height of mounting profiles (8) for apparatus (9) and of that of a covering (18) above a mounting base, the basic profiles (1) having two flanges (3,4) which are perpendicular to each other and of which the shorter flange (4), serving for attachment on the mounting base, is provided with a groove (5) which is inwardly open perpendicularly to said flange and suitable for the attachment of mounting profiles (8), the other flange (3) having at its end an outwardly open groove (6) adapted for direct attachment of the covering (18) by means of nuts (11,12) and screws (10), and internally thereof at least one groove (7) which is inwardly open perpendicularly to said flange (3) and adapted to receive one shank of the connecting angle (20), wherein a frame profile (2) is further provided whose cross-section corresponds to the portion of said other flange (3) of the basic profile (1) including the two grooves (6,7), and wherein a partitioning profile (14) is provided having two grooves (15) which are open on the same side for the insertion of nuts in view of securing the covering (18), as well as a connecting angle (13), in order to connect the partitioning profile (14) to said groove (7) which is inwardly open perpendicularly to said other flange (3) at a predeterminable height, in such a manner that the grooves (15) of the partitioning profile lie on the same level as the outwardly open groove (6) of said other flange.

2. Construction set according to claim 1, characterized by a partitioning profile (14) having a web (16) between said groove openings projecting therefrom.

3. Construction set according to one of claims 1 or 2, characterized in that a single type of angle (13) for connecting a mounting (8) or a partitioning profile (14) to a basic profile (1) is provided.

4. Construction set according to one of claims 1 to 3, characterized by another profile having two lateral mounting flanges (26) and between them a groove (30) which is open perpendicularly to said mounting flanges (Fig. 8).

5. Construction set according to one of claims 1 to 4, characterized by another profile having two lateral mounting flanges (26) and between them two grooves (28,29) which are open perpendicularly to said flanges and disposed at different levels (Fig. 7).

6. Construction set according to one of claims 1 to 5, characterized in that the connecting angle (20) for basic profiles (1) or frame profiles (2) comprises a respective inclined clamping screw (21), a point (23) of which is adapted to be pressed against the groove floor.

**FIG.1**

FIG.2

FIG.3

FIG.4

FIG.5

FIG.6

FIG.7

FIG.8

# FIG.9